# EUROPÄISCHE PATENTSCHRIFT

(11) **EP 3 229 568 B1**
(45) Veröffentlichungstag und Bekanntmachung des Hinweises auf die Patenterteilung: **05.05.2021**
(21) Anmeldenummer: 17000384.2
(22) Anmeldetag: 10.03.2017
(51) Int. Cl.: H05K 5/06

(54) **GEHÄUSE**
HOUSING
BOÎTIER

(30) Priorität: 04.04.2016 DE 102016003831; 07.06.2016 DE 102016006978
(43) Veröffentlichungstag der Anmeldung: 11.10.2017
(73) Patentinhaber: Diehl Metering GmbH, 91522 Ansbach (DE)
(72) Erfinder: Seifert, Andreas, DE - 91725 Ehingen (DE); Gronauer, Christoph, DE - 90602 Pyrbaum (DE)
(74) Vertreter: Diehl Patentabteilung

(56) Entgegenhaltungen:
- DE-A1-102009 013 111
- JP-A- H11 243 283

## Beschreibung

Die Erfindung ist im beigefügten Anspruchssatz beschrieben und betrifft ein Gehäuse bestehend aus wenigstens einem ersten und einem zweiten Gehäuseteil, die miteinander verbunden sind, sowie mit wenigstens einem in das Gehäuseteil eingeführten oder aus dem Gehäuseherausgeführten Leitungs- oder Anschlusselement.

In einem solchen Gehäuse befindet sich üblicherweise ein oder mehrere Elektronikbauteile, die der Durchführung unterschiedlichster Aufgaben dienen. Es kann sich z. B. um eine Messelektronik oder eine Steuerelektronik handeln, siehe z. B. JP H11 243283 und DE 10 2009 013111. Üblicherweise ist es erforderlich, die Elektronikbauteile vor Umwelteinflüssen zu schützen, sie also entsprechend zu kapseln. Daher ist eine entsprechende Abdichtung des Gehäuses erforderlich. Hierzu sind unterschiedliche Möglichkeiten bekannt. Zum einen besteht die Möglichkeit, das Gehäuse vollständig in eine Vergussmasse einzubetten, es also vollständig zu vergießen. Eine andere Alternative sieht vor, zwischen die beiden Gehäuseteile entsprechende Dichtungen einzulegen, an denen die Gehäuseteile anliegen und über die sie relativ zueinander abgedichtet werden. Eine dritte Möglichkeit sieht vor, die Gehäuseteile miteinander zu verschweißen, um einen dichten Raum zu bilden. Bei Gehäuseteilen aus Kunststoff kann dies beispielsweise durch Ultraschallschweißen oder Laserschweißen erfolgen.

Diese verschiedenen Abdichtmöglichkeiten sind relativ aufwändig und umständlich. Es wird bei einem Vollverguss sehr viel Vergussmasse benötigt, während bei Verwendung eines oder mehrerer separater Dichtelemente diese vorgehalten und montiert werden müssen. Das Verschweißen der Gehäuseteile erfordert einerseits einen separaten Arbeitsvorgang, zum anderen wird die entsprechende Schweißvorrichtung benötigt.

Der Erfindung liegt das Problem zugrunde, ein demgegenüber verbessertes Gehäuse anzugeben.

Zur Lösung dieses Problems ist bei einem Gehäuse der eingangs genannten Art erfindungsgemäß vorgesehen, dass am ersten Gehäuseteil eine umlaufende Nut vorgesehen ist, in die eine am zweiten Gehäuseteil vorgesehene umlaufende Kante eingreift, die gleichzeitig das Leitungs- oder Anschlusselement in die Nut drückt, wobei die Nut zumindest teilweise mit einem ausgehärteten Dichtmittel gefüllt ist, das den Übergang zwischen den beiden Gehäuseteilen abdichtet und das Leitungs- oder Anschlusselement umschließt.

Das erfindungsgemäße Gehäuse lässt einerseits eine vollständige Abdichtung zwischen den Gehäuseteilen und damit die Ausbildung eines komplett abgedichteten Hohlraums zu, zum anderen ist gleichzeitig sichergestellt, dass auch die Zu- oder Ausführung für das Leitungs- oder Anschlusselement vollkommen abgedichtet ist. Zu diesem Zweck ist das erste Gehäuseteil mit einer umlaufenden Nut versehen. Hierzu ist das topf- oder schalenartige erste Gehäuseteil mit einem benachbart zur Außenwand umlaufenden Steg versehen, so dass sich zwischen der jeweiligen Außenwand und dem Steg eine umlaufende Nut ausbildet. Am ebenfalls topf- oder schalenförmigen zweiten Gehäuseteil ist eine umlaufende Kante vorgesehen, die beispielsweise durch die Randkante der Seitenwände des zweiten Gehäuseteils selbst gebildet sein kann. Beim Aufsetzen des zweiten Gehäuseteils auf das erste Gehäuseteil greift die umlaufende Kante des zweiten Gehäuseteils in die Nut. Diese Nut ist erfindungsgemäß mit einem Dichtmittel gefüllt, so dass die umlaufende Kante des zweiten Gehäuseteils zwangsläufig in das beim Zusammensetzen der Gehäuseteile noch viskose Dichtmittel eintaucht. Gleichzeitig wird über die Kante aber auch das Leitungs- oder Anschlusselement, das von außen in das Gehäuse eingeführt oder von Innen aus dem Gehäuse herausgeführt wird, in die Nut des ersten Gehäuseteils hineingedrückt und, da die Kante in das Dichtmittel eingreift, zwangsläufig ebenfalls unter das Niveau des Dichtmittels gedrückt, so dass das Dichtmittel auch das Leitungs- oder Anschlusselement vollständig umschließt respektive einbettet. Härtet nun das Dichtmittel aus, so ist folglich ein vollständig dichter Übergang zwischen den beiden Gehäuseteilen wie auch zum Kabel gegeben. Der innere Gehäuseraum, in dem die Elektronik, gleichwie diese ausgebildet ist respektive welche Funktion diese hat, angeordnet ist, ist damit vollständig gekapselt. Ein solches Leitungs- oder Anschlusselement kann z. B. ein ein- oder mehradriges Kabel sein, oder ein Metalldraht, der entsprechend gebogen ist und z. B. als Pin am Gehäuse absteht. Auch ein Antenne, z. B. in Form eines Antennenblechs, kann ein solches Leitungs- oder Anschlusselement sein, also ein Sende- und Empfangsbauteil.

Natürlich besteht die Möglichkeit auch mehr als ein Leitungs- oder Anschlusselement in das Gehäuse zu führen. In diesem Fall werden über die Kante des zweiten Gehäuseteils natürlich sämtliche zugeführten Leitungs- oder Anschlusselemente in das Dichtmittel eingedrückt, so dass alle Leitungs- oder Anschlusselemente vom Dichtmittel im Nutbereich vollständig umhüllt sind. Dabei kann die Zuführung des Leitungs- oder Anschlusselements an einer gemeinsamen Position oder Seite des Gehäuses erfolgen, oder an verschiedenen Positionen. Dies ermöglicht es, die Leitungs- oder Anschlusselemente quasi beliebig zuzuführen, wobei das Funktionsprinzip stets das gleiche ist, das heißt, dass jedes Leitungs- oder Anschlusselement, egal wo die Zuführposition ist, über die umlaufende Kante des zweiten Gehäuseteils in die Nut und damit in das Dichtmittel eingedrückt wird.

Die Kante des zweiten Gehäuseteils kann, abgesehen von dem Kantenabschnitt, der am Leitungs- oder Anschlusselement angreift, am Boden der Nut aufliegen oder von diesem etwas beabstandet sein. Das heißt, dass unterschiedliche Möglichkeiten gegeben sind, wieweit sich die Kante in die Nut erstreckt. Lediglich der oder die Abschnitte, der oder die am Kabel angreifen, müssen etwas vom Boden beabstandet sein, da zwischen Kante und Boden das oder die Leitungs- oder Anschlusselemente verlaufen.

Bevorzugt ist die Nut am ersten Gehäuseteil in dem Bereich, in dem das Leitungs- oder Anschlusselement durch die Nut geführt ist, etwas verbreitert, damit das von außerhalb kommende Leitungs- oder Anschlusselement mit einer im Wesentlichen U-förmigen Biegung nach unten in die Nut und aus dieser auf der der Kante des zweiten Gehäuseteils gegenüberliegenden Seite wieder herausgeführt werden kann. Die Nut kann damit in allen anderen Bereichen sehr schmal ausgeführt werden, so dass insgesamt sehr wenig Dichtmaterial benötigt wird. Lediglich im Zuführbereich des Leitungs- oder Anschlusselements ist die Nut etwas verbreitert. Dieser Spalt markiert die minimale Füllhöhe des flüssigen Dichtmittels.

Der Abschnitt der Kante des zweiten Gehäuseteils, der in den verbreiterten Bereich der Nut eingreift, ist in Weiterbildung der Erfindung bezüglich der Außenseite des zweiten Gehäuseteils nach innen versetzt. Dies ermöglicht es, das z. B. einlaufende Leitungs- oder Anschlusselement in Form eines Kabels zunächst entlang der Innenwand des ersten Gehäuseteils nach unten in die Nut zu führen, wo es sodann quasi parallel zum Boden der Nut verläuft, in welche Position es über die Kante des zweiten Gehäuseteils gedrückt ist, wonach das Kabel wieder aus der Nut nach oben zur Elektronik geführt ist. Die Beabstandung des Kantenabschnitts ermöglicht es, das Kabel in dieser Form von außen kommend in die Nut zu führen. Der Abschnitt der Kante weist dabei bevorzugt eine im Wesentlichen rechtwinklige Form auf, kann aber je nach Geometrie des Gehäuses auch gegebenenfalls anders gestaltet sein.

Um das Leitungs- oder Anschlusselement in seiner Position am ersten Gehäuseteil zu fixieren, kann in Weiterbildung der Erfindung am ersten Gehäuseteil wandseitig ein Halteelement, an dem das Leitungs- oder Anschlusselement fixiert ist, vorgesehen sein. Das heißt, dass an der Innenwand des ersten Gehäuseteils ein entsprechendes Bauteil ausgebildet oder vorgesehen ist, an dem das Leitungs- oder Anschlusselement befestigt werden kann, so dass es seitlich nicht verrutschen kann. Ein solches Halteelement kann beispielsweise klammer- oder clipartig ausgeführt sein, so dass das Leitungs- oder Anschlusselement darin eingeschnappt oder eingepresst, also klemmfixiert werden kann.

Ein solches Halteelement kann entweder an einem innenwandseitigen Befestigungsabschnitt des ersten Gehäuseteils befestigt sein, das heißt, dass das Halteelement als separates Bauteil ausgebildet ist, das gehäusewandseitig befestigt wird. Es kann beispielsweise in eine Nut, die gehäusewandseitig ausgebildet ist, eingesteckt und dort beispielsweise verklebt werden, oder über eine Schnappverbindung dort fixiert sein. Werden mehrere Leitungs- oder Anschlusselemente zu- oder herausgeführt, die jeweils in einem Halteelement fixiert sind, so besteht die Möglichkeit, an einem gemeinsamen separaten Bauteil mehrere Halteelemente auszubilden, so dass nur ein solches Bauteil, das die Befestigung mehrerer Leitungs- oder Anschlusselemente ermöglicht, zu montieren ist. Die Halteelemente sind an dem Bauteil nebeneinanderliegend ausgebildet.

Daneben besteht die Möglichkeit, ein solches Halteelement auch einstückig am Gehäusebauteil auszubilden, was insbesondere dann ohne weiteres möglich ist, wenn das Gehäuseteil aus Kunststoff ist und entsprechende Geometrien bei der Herstellung des Kunststoffteils ausgeformt werden können.

Ferner kann an der Kantenoberseite der Kante des ersten Gehäuseteils ein oder mehrere Niederhalter, unter die ein Leitungs- oder Anschlusselement geklemmt werden kann, vorgesehen bzw. angeformt sein. Diese nehmen die Kraft, die zum Verformen des oder der Leitungs- oder Anschlusselemente, z. B. der Kabel benötigt werden auf und entlasten damit den Zusammenhalt beider Gehäusehälften.

Um ein Leitungs- oder Anschlusselement definiert zu- oder herausführen zu können ist es zweckmäßig, wenn entweder an einem Gehäuseteil eine Ausnehmung wandseitig vorgesehen ist, durch die das Kabel geführt wird. Eine solche Ausnehmung ist kantenseitig vorgesehen, so dass das Leitungs- oder Anschlusselement auf einfache Weise in diese Ausnehmung eingelegt werden kann. Denkbar ist es auch, an beiden Gehäuseteilen miteinander korrespondierende Ausnehmungen an den Außenwänden vorzusehen, die sich zu einer Öffnung ergänzen, durch die das Leitungs- oder Anschlusselement geführt ist. Solche Ausnehmungen können beispielsweise halbkreisförmig ausgeführt sein oder dergleichen.

Das Dichtmittel selbst ist bevorzugt eine Dichtmasse oder ein Gießharz auf Kunststoffbasis. Als Dichtmasse kann beispielsweise eine Dichtmasse auf Silikonbasis verwendet werden, als Gießharz wird bevorzugt ein Gießharz auf Polyurethanbasis oder Epoxidbasis verwendet.

Die Gehäuseteile selbst sind wie beschrieben bevorzugt aus Kunststoff, was ebenfalls für das Halteelement, sofern dieses ein separates Bauteil ist, gelten kann.

Wenngleich es für die Fixierung der beiden Gehäuseteile aneinander bereits ausreichend ist, wenn die beiden Gehäuseteile über das ausgehärtete, also sehr feste Dichtmittel miteinander verbunden sind, ist es in Weiterbildung der Erfindung zweckmäßig, die beiden Gehäuseteile zusätzlich über Rastverbindungen oder Schraubverbindungen miteinander zu verbinden. Insbesondere bei der Ausführung der Gehäuseteile aus Kunststoff ist es ohne weiteres möglich, beispielsweise entsprechende Rastabschnitte im Bereich der Seitenwände oder Kanten vorzusehen, die beim Zusammensetzen der Gehäuseteile miteinander verrasten. Auch können entsprechende Schraubenlöcher oder ähnliches ohne weiteres ausgebildet werden, wie auch Gewindemuffen und der gleichen ohne weiteres in die Kunststoffgehäuseteile eingegossen werden können. Alternativ kann das Gehäuse auch aus Metallteilen bestehen, die ebenfalls in entsprechender Weise bevorzugt über Schraubverbindungen miteinander verbunden sind.

Neben dem Gehäuse selbst betrifft die Erfindung ferner ein Verfahren zur Herstellung eines Gehäuses, das aus wenigstens einem ersten und einem zweiten Gehäuseteil, die miteinander verbunden und gegeneinander abgedichtet sind, besteht, mit wenigstens einem in das oder aus dem Gehäuse geführten, zu wenigstens einem Gehäuseteil abgedichteten Leitungs- oder Anschlusselement, bei dem
- entweder wenigstens ein Leitungs- oder Anschlusselement in das erste Gehäuseteil eingeführt wird und in eine an dem ersten Gehäuseteil ausgebildete umlaufende Nut ein fluides Dichtmittel eingebracht wird, wonach das zweite Gehäuseteil mit einer umlaufenden Kante in die Nut eingesetzt wird, so dass das Dichtmittel den Übergang zwischen den beiden Gehäuseteilen in der Nut abdichtet und das Leitungs- oder Anschlusselement über die Kante unter das Niveau des Dichtmittels gedrückt wird, wonach das Dichtmittel aushärtet,
- oder wenigstens ein Leitungs- oder Anschlusselement in das erste Gehäuseteil eingeführt wird und das zweite Gehäuseteil mit einer umlaufenden Kante in eine an dem ersten Gehäuseteil ausgebildete umlaufende Nut eingesetzt wird und das Leitungs- oder Anschlusselement über die Kante in die Nut gedrückt wird, wonach in die Nut ein den Übergang zwischen den beiden Gehäuseteilen in der Nut abdichtendes und das Leitungs- oder Anschlusselement in der Nut umschließendes fluides Dichtmittel eingebracht wird, das anschließend aushärtet.

Die beiden Verfahrensvarianten unterscheiden sich also hinsichtlich des Zeitpunkts, zudem das Dichtmittel in die Nut eingebracht wird. Gemäß der ersten Alternative wird die Nut mit dem Dichtmittel vor dem Aufsetzen des zweiten Gehäuseteils gefüllt, so dass die umlaufende Kante des zweiten Gehäuseteils beim Aufsetzen in das Dichtmittel eintaucht. Bei der zweiten Alternative wird zuerst das zweite Gehäuseteil auf das erste Gehäuseteil gesetzt, wonach das Dichtmittel in die Nut gefüllt wird und sich in dieser verteilt, so dass die umlaufende Kante des zweiten Gehäuseteils ebenfalls beidseitig in das Dichtmittel eingebettet ist. Der Füllgrad des Dichtmittels wird natürlich jeweils so gewählt, dass sichergestellt ist, dass die umlaufende Kante des zweiten Gehäuseteils tief genug in das Dichtmittel eingreift.

Weitere Vorteile und Einzelheiten der Erfindung ergeben sich aus den im Folgenden beschriebenen Ausführungsbeispielen sowie anhand der Zeichnungen. Dabei zeigen:
- Fig. 1: eine Aufsicht auf die Innenseite des ersten Gehäuseteils,
- Fig. 2: eine perspektivische Teilansicht des ersten Gehäuseteils mit einem darin eingeführten Kabel,
- Fig. 3: eine Aufsicht auf die Innenseite des zweiten Gehäuseteils,
- Fig. 4: eine Teilansicht des zweiten Gehäuseteils aus Fig. 3,
- Fig. 5: eine Schnittansicht durch ein erfindungsgemäßes Gehäuse im vergossenen Zustand, und
- Fig. 6: eine vergrößerte Detailansicht des Bereichs der Kabelzuführung.

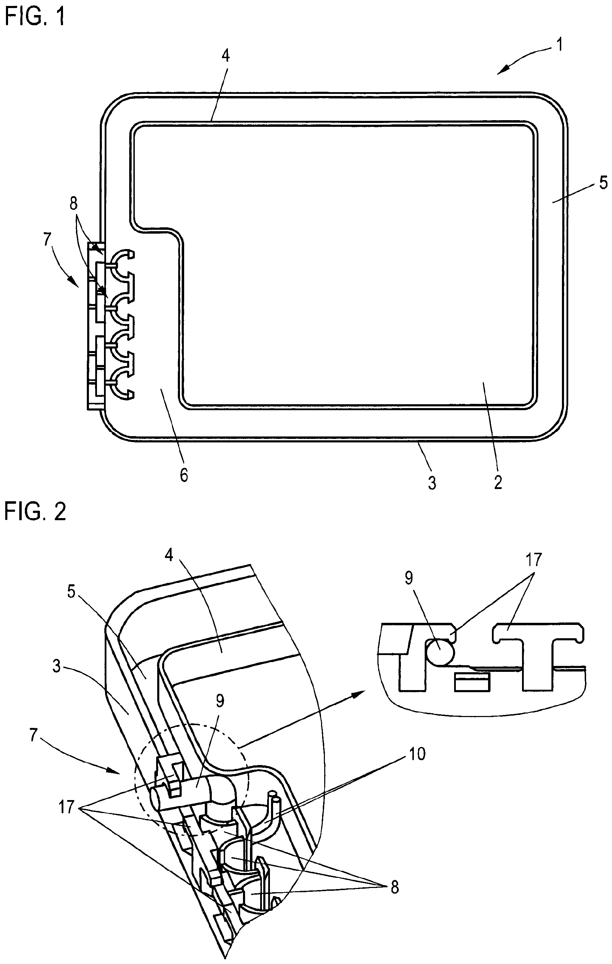

Fig. 1 zeigt ein erstes Gehäuseteil 1, das schalenförmig ausgeführt ist und einen Boden 2 sowie vier umlaufende Seitenwände 3 aufweist. Am Boden 2 ist ein umlaufender Steg 4 vorgesehen, so dass sich zwischen den Seitenwänden 3 und dem umlaufenden Steg 4 eine umlaufende Nut 5 ausbildet, die einen verbreiterten Bereich 6 aufweist, in welchem

Bereich eine Kabelzuführung 7 vorgesehen ist. Zur Fixierung eines oder mehrerer zu- oder herauszuführender Leitungs- oder Anschlusselemente, z. B. in Form eines oder mehrerer Kabel ist ein oder sind mehrere Haltelemente 8 vorgesehen, die im gezeigten Beispiel als einstückiges gemeinsames Bauteil ausgeführt sind und in nachfolgend noch zu beschreibender Weise in entsprechenden Halteaufnahmen an der Innenseite der dortigen Seitenwand 3 fixiert sind. Die Halteelemente weisen im Wesentlichen eine C-Form auf und sind damit klammer- oder clipartig ausgeführt, so dass ein Leitungs- oder Anschlusselement in ein solches Haltelement 8 eingeschnappt werden kann.

Die Höhe des Steges 4 ist bevorzugt etwas niedriger bemessen als die Höhe der Seitenwände 3. Sie ist jedoch so bemessen, dass in die Nut 5 ein fluides Dichtmittel mit hinreichendem Füllstand eingebracht werden kann, das der Abdichtung des fertigen Gehäuses dient. Die unterschiedliche Steghöhe verglichen zur Höhe der Seitenwände ist auch in Fig. 2 ersichtlich, die einen Ausschnitt des ersten Gehäuseteils 1 im Bereich der Zuführung 7 z. B. für ein Kabel zeigt. Gut zu erkennen sind die Haltelemente 8, wobei in einem Halteelement 8 ein Kabel 9, das ein Leitungs- oder Anschlusselement darstellt, eingeschnappt ist. Das Kabel 9 ist hierzu um 90° relativ zu seiner Zulaufrichtung gebogen und im Halteelement 8 eingesetzt. Die beiden Litzen 10 des Kabels 9 sind im weiter innenliegenden Bereich freigelegt und laufen durch die Nut 5 hin zu einer nicht näher gezeigten Elektronik, die im Gehäuse montiert ist.

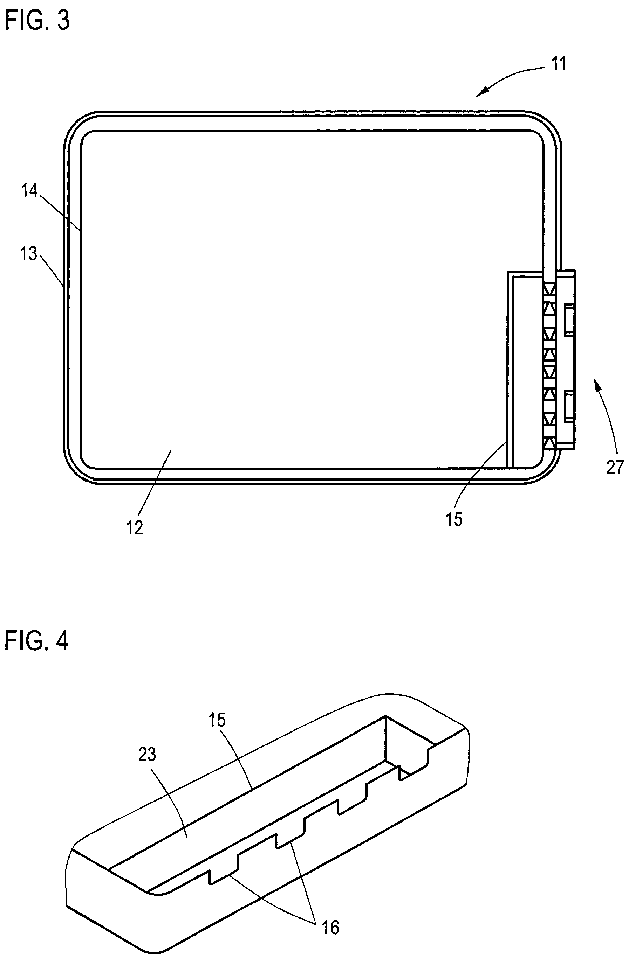

Fig. 3 zeigt das zweite Gehäuseteil 11, das ebenfalls schalenförmig ausgeführt ist und einen Boden 12 sowie Seitenwände 13 aufweist. Die Seitenwände 13 bilden eine umlaufende Kante 14 aus, wobei ein Kantenabschnitt 15, der hier rechtwinklig ausgeführt ist, etwas relativ zur benachbarten Seitenwand nach innen gezogen ist. Dieser Kantenabschnitt 15 dient dazu, das Kabel 9 respektive dessen Litzen 10 tief in die Nut 5 in dem erweiterten Bereich 6 hineinzudrücken und damit unter das Niveau des eingefüllten Dichtmittels zu bringen, worauf nachfolgend noch eingegangen wird.

Auch am zweiten Gehäuseteil 11, siehe Fig. 4, ist eine Kabelzuführung 27 ausgebildet, an der exemplarisch Ausnehmungen 16 vorgesehen sind, durch die das Kabel 9, das exemplarisch unter einem Niederhalter 17 am ersten Gehäuseteil (siehe Fig. 2) eingeklemmt ist, durchgeführt wird respektive die den Niederhalter 17 aufnehmen. Ein solcher Niederhalter 17, unter den das Kabel 9 geklemmt wird, ist jedem Halteelement 8 zugeordnet.

Zur Montage des Gehäuses wird, nachdem das Gehäuseunterteil oder das Gehäuseoberteil mit den entsprechenden Elektronikkomponenten bestückt wurde, zunächst das oder werden die Kabel 9 in den Halteelementen 8 und an den entsprechenden Niederhaltern 17 fixiert und an den entsprechenden Elektronikkomponenten angeschlossen.

Sodann wird beispielsweise noch vor dem Aufsetzen des zweiten Gehäuseteils 11 auf das erste Gehäuseteils 1 die Nut 5 mit einer vorabbestimmten Menge eines fluiden Dichtmittels, beispielsweise einer fluiden Dichtmasse auf Silikonbasis oder einem Gießharz auf Polyurethan- oder Epoxidharzbasis gefüllt, so dass ein definiertes Füllstandsniveau erreicht wird.

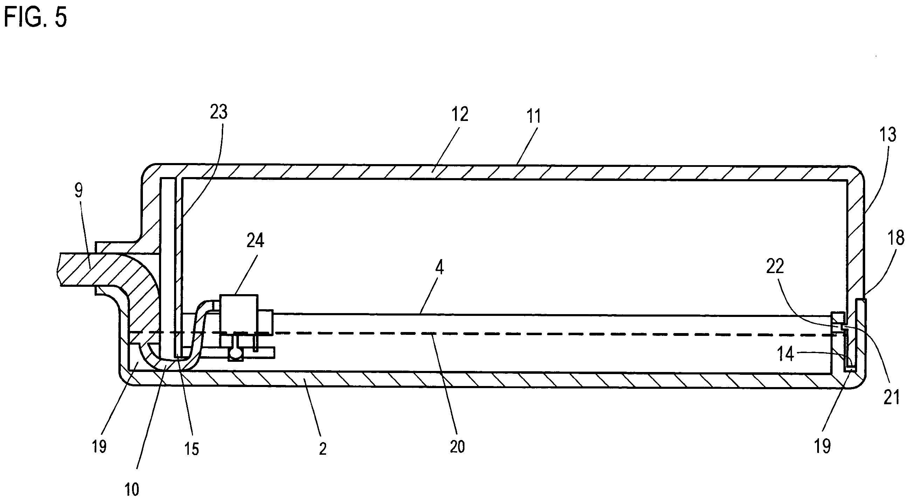

Im nächsten Schritt wird das zweite Gehäuseteil 11 aufgesetzt, derart, dass es mit seiner umlaufenden Kante 14 in die Nut 5 eingreift. Wie in der Schnittansicht gemäß Fig. 5 dargestellt ist, ist an den Seitenwänden 13 des zweiten Gehäuseteils 11 ein Anschlag 18 ausgebildet, der die Einschiebebewegung begrenzt. Die umlaufende Kante 14 ist so bemessen, dass sie tief in das Dichtmittel 19 eintaucht, deren Füllstandniveau 20 in der Schnittansicht gemäß Fig. 5 dargestellt ist. Das fluide Dichtmittel befindet sich folglich beidseits des in die Nut 5 eintauchenden Abschnitts des zweiten Gehäuseteils 11, so dass eine vollständige Abdichtung zwischen den beiden Gehäuseteilen gegeben ist. Zur Fixierung der Gehäuseteile 1 und 11 aneinander sind beispielsweise an dem zweiten Gehäuseteil 11 entsprechende Rast- oder Schnappvorsprünge 21 ausgebildet, die in entsprechende Rast- oder Schnappaufnahmen 22 am ersten Gehäuseteil im Bereich des Steges 4 einschnappen.

Fig. 5 zeigt des Weiteren, dass auch das Kabel 9 respektive seine freigelegten Litzen 10 vollständig in das Dichtmittel 19 eingebettet sind. Einerseits verläuft das Kabel 9 in Richtung des Bodens 2 des ersten Gehäuseteils, so dass es bereits in Richtung der Nut 5 geführt ist. Andererseits werden die Litzen 10 über den Kantenabschnitt 15 der Kante 14, der an einem entsprechenden Steg 23, der vom Boden 12 des zweiten Gehäuseteils 11 absteht, ausgebildet ist, in Richtung des Bodens 2 und damit tief in den erweiterten Bereich 6 der Nut 5 gedrückt. Die Höhe dieses Steges 23 und damit die Lage des Kantenabschnitts 15 ist so bemessen, dass die Litzen 10 definitiv unterhalb des Füllstandniveaus 20 des fluiden Dichtmittels 19 liegen. Wie Fig. 5 zeigt laufen die Litzen 10 auf der anderen Seite des Stegs 23 wieder nach oben und sind an die entsprechende im Gehäuse verbaute Elektronik 26 angeschlossen. Damit ist auch im Bereich der Kabelzuführung eine vollständige Abdichtung zwischen den Gehäuseteilen 1 und 11 gegeben, da das fluide Dichtmittel auch den Steg 23 vollständig im Nutbereich einbettet, wie auch eine Abdichtung zu dem oder den Kabeln 9 respektive dessen Litzen 10 gegeben ist.

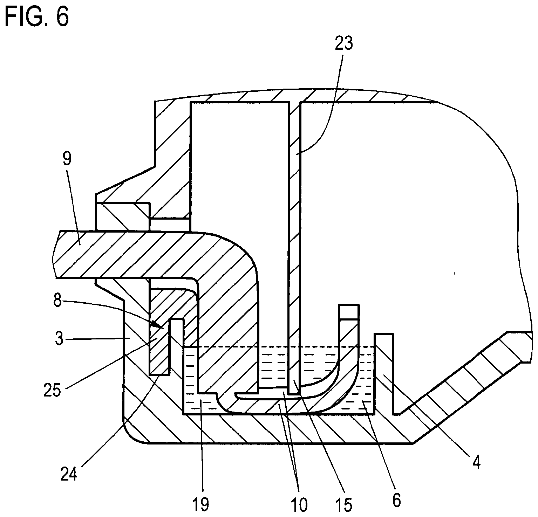

Fig. 6 zeigt schließlich eine vergrößerte Darstellung des Kabelzuführbereichs des vergossenen Gehäuses. In dieser Darstellung ist einerseits ein Befestigungsabschnitt 24 an der Wand 3 des ersten Gehäuseteils 1 gezeigt, an dem ein Bauteil 25, an dem die Halteelemente 8 ausgebildet sind, eingesetzt ist und dort beispielsweise verklebt ist.

Gezeigt ist des Weiteren das Kabel 9 in seiner Führung in das Gehäuse sowie die Weiterführung seiner Litzen 10 durch die Nut 5 respektive den verbreiterten Nutabschnitt 6. Gezeigt ist des Weiteren die Einbettung des Steges 23 sowie der Litzen 10 in das ausgehärtete Dichtmittel 19.

Insgesamt ist folglich eine vollständige Abdichtung des Gehäuseinneren zur Gehäuseumgebung realisiert, wozu sehr wenig Dichtmittel benötigt wird.

Alternativ zur beschriebenen Möglichkeit, das Dichtmittel vor dem Aufsetzen des zweiten Gehäuseteils in die Nut 5 einzubringen, besteht die Möglichkeit, zunächst das zweite Gehäuseteil 11 auf das erste Gehäuseteil 1 zu setzen und beide miteinander zu verschnappen und erst dann das fluide Dichtmittel in die Nut 5 einzubringen. Hierzu ist eine entsprechende Zuführöffnung vorzusehen, durch die das fluide Dichtmittel in die Nut fließen kann. In dieser verteilt es sich, bis ein entsprechendes Füllniveau erreicht ist. Zumindest in dem Bereich des Kantenabschnitts 15, der zwangsläufig etwas vom Boden 2 des ersten Gehäuseteils beabstandet sein muss, da unterhalb des Kantenabschnitts 15 ja die Litzen 10 verlaufen, ist eine Möglichkeit gegeben, dass das Dichtmittel zu beiden Seiten der Kante 14 des Stegs 23 respektive der umlaufenden Seitenwände 13 des zweiten Gehäuseteils fließen kann und mithin eine umlaufende vollständige Einbettung im Nutbereich gegeben ist, selbst wenn sich die Kante 14 bis zum Boden 2 oder bis nahe dem Boden 2 erstreckt.

An dem Gehäuse selbst können, wenngleich nicht näher dargestellt, mehrere Kabel zugeführt werden, wie auch verschiedene Zuführbereiche für die Kabel vorgesehen sein können. Das Grundprinzip der Abdichtung ist jedoch stets das gleiche.

Ferner sind am Gehäuse, je nach Aufgabe oder Funktion der verbauten Elektronik, entsprechende Betätigungselemente wie Taster, Schalter, Touchscreens etc. oder Anzeigeelemente wie Leuchten, Displays oder dergleichen vorgesehen, die in den Prinzipdarstellungen nicht näher gezeigt sind.

### Bezugszeichenliste

- 1: Gehäuseteil
- 2: Boden
- 3: Seitenwand
- 4: Steg
- 5: Nut
- 6: Bereich
- 7: Kabelzuführung
- 8: Halteelement
- 9: Leitungs- oder Anschlusselement
- 10: Litze
- 11: Gehäuseteil
- 12: Boden
- 13: Seitenwand
- 14: Kante
- 15: Kantenabschnitt
- 16: Ausnehmung
- 17: Niederhalter
- 18: Anschlag
- 19: Dichtmittel
- 20: Füllstandniveau
- 21: Schnappvorsprung
- 22: Schnappaufnahme
- 23: Steg
- 24: Befestigungsabschnitt
- 25: Bauteil
- 26: Elektronik
- 27: Kabelzuführung

## Patentansprüche

1. Gehäuse bestehend aus wenigstens einem ersten und einem zweiten Gehäuseteil, die miteinander verbunden sind, sowie mit wenigstens einem in das Gehäuse eingeführten oder aus dem Gehäuse herausgeführten Leitungs- oder Anschluss-element, wobei am ersten Gehäuseteil (1) eine umlaufende Nut (5) vorgesehen ist, in die eine am zweiten Gehäuseteil (11) vorgesehene umlaufende Kante (14, 15) eingreift, die gleichzeitig das Leitungs- oder Anschlusselement (9) in die Nut (5) drückt, wobei die Nut (5) zumindest teilweise mit einem ausgehärteten Dichtmittel (19) gefüllt ist, das den Übergang zwischen den beiden Gehäuseteilen (1, 11) abdichtet und das Leitungs- oder Anschlusselement (9) umschließt, **dadurch gekennzeichnet, dass** die Nut (5) in dem Bereich (6), in dem das Leitungs- oder Anschlusselement (9) durch die Nut (5) geführt ist, verbreitert ist, wobei der Abschnitt (15) der Kante (14) des zweiten Gehäuseteils (11), der in den verbreiterten Bereich (6) der Nut (5) eingreift, bezüglich einer benachbarten Seitenwand (13) des zweiten Gehäuseteils (11) nach innen versetzt verläuft.

2. Gehäuse nach Anspruch 1, **dadurch gekennzeichnet, dass** die Kante (14) des zweiten Gehäuseteils (11), abgesehen von dem Kantenabschnitt (15), der am Leitungs- oder Anschlusselement (9) angreift, am Boden (2) der Nut (5) aufliegt oder von diesem beanstandet ist.

3. Gehäuse nach einem der vorangehenden Ansprüche, **dadurch gekennzeichnet, dass** der Abschnitt (15) der Kante (14) eine im wesentlichen rechtwinklige Form aufweist.

4. Gehäuse nach einem der vorangehenden Ansprüche, **dadurch gekennzeichnet, dass** am ersten Gehäuseteil (1) wandseitig ein Halteelement (8), an dem das Leitungs- oder Anschlusselement (9) fixiert ist, vorgesehen ist.

5. Gehäuse nach Anspruch 4, **dadurch gekennzeichnet, dass** das Halteelement (8) klammer- oder clipartig und das Leitungs- oder Anschlusselement (9) darin eingeschnappt oder eingepresst ist.

6. Gehäuse nach Anspruch 4 oder 5, **dadurch gekennzeichnet, dass** das Halteelement an einem wandseitigen Befestigungsabschnitt (24) befestigt ist, oder dass es einstückig am Gehäuseteil (1) ausgebildet ist.

7. Gehäuse nach einem der vorangehenden Ansprüche, **dadurch gekennzeichnet, dass** an der Kante des ersten Gehäuseteils (1) ein oder mehrere Niederhalter (17) vorgesehen sind, unter die das Leitungs- oder Anschlusselement (9) geklemmt ist.

8. Gehäuse nach einem der vorangehenden Ansprüche, **dadurch gekennzeichnet, dass** an einem Gehäuseteil (1, 11) eine Ausnehmung (16) oder an beiden Gehäuseteilen (1, 11) miteinander korrespondierende Ausnehmungen an den Außenwänden vorgesehen sind, die sich zu einer Öffnung ergänzen, durch die das Leitungs- oder Anschlusselement (9) geführt ist.

9. Gehäuse nach einem der vorangehenden Ansprüche, **dadurch gekennzeichnet, dass** das Dichtmittel (19) eine Dichtmasse oder ein Gießharz auf Kunststoffbasis ist.

10. Gehäuse nach Anspruch 9, **dadurch gekennzeichnet, dass** die Dichtmasse auf Silikonbasis oder das Gießharz auf Polyurethanbasis oder Epoxidbasis ist.

11. Gehäuse nach einem der vorangehenden Ansprüche, **dadurch gekennzeichnet, dass** die Gehäuseteile (1, 11) und gegebenenfalls das Halteelement (8) aus Kunststoff sind.

12. Gehäuse nach einem der vorangehenden Ansprüche, **dadurch gekennzeichnet, dass** die beiden Gehäuseteile (1, 11) über Rastverbindungen oder Schraubverbindungen miteinander verbunden sind.

13. Gehäuse nach einem der vorangehenden Ansprüche, **dadurch gekennzeichnet, dass** das Leitungs- oder Anschlusselement (9, 10) ein Kabel, ein Metalldraht, insbesondere in Form eines Pins, oder ein Sende- oder Empfangselement mit einer Antenne ist.

14. Verfahren zur Herstellung eines Gehäuses, das aus wenigstens einem ersten und einem zweiten Gehäuseteil, die miteinander verbunden und gegeneinander abgedichtet sind, besteht, mit wenigstens einem in das oder aus dem Gehäuse geführten, zu wenigstens einem Gehäuseteil abgedichteten Leitungs- oder Anschlusselement, bei dem
- entweder wenigstens ein Kabel (9) in das erste Gehäuseteil (1) eingeführt wird und in eine an dem ersten Gehäuseteil (1) ausgebildete umlaufende Nut (5) ein fluides Dichtmittel (19) eingebracht wird, wonach das zweite Gehäuseteil (11) mit einer umlaufenden Kante (14, 15) in die Nut (5) eingesetzt wird, so dass das Dichtmittel (19) den Übergang zwischen den beiden Gehäuseteilen (1, 11) in der Nut (5) abdichtet und das Leitungs- oder Anschlusselement (9, 10) über die Kante (14, 15) unter das Niveau (20) des Dichtmittels (19) gedrückt wird, wonach das Dichtmittel aushärtet,
- oder wenigstens ein Leitungs- oder Anschlusselement (9) in das erste Gehäuseteil (1) eingeführt wird und das zweite Gehäuseteil (11) mit einer umlaufenden Kante (14, 15) in eine an dem ersten Gehäuseteil (1) ausgebildete umlaufende Nut (5) eingesetzt wird und das Leitungs- oder Anschlusselement (9) über die Kante (14, 15) in die Nut (5) gedrückt wird, wonach in die Nut (5) ein den Übergang zwischen den beiden Gehäuseteilen (1, 11) in der Nut (5) abdichtendes und das Leitungs- oder Anschlusselement (9, 10) in der Nut (5) umschließendes fluides Dichtmittel (19) eingebracht wird, das anschließend aushärtet,
wobei in beiden Fällen die Nut (5) in dem Bereich (6), in dem das Leitungs- oder Anschlusselement (9) durch die Nut (5) geführt ist, verbreitert ist, wobei der Abschnitt (15) der Kante (14) des zweiten Gehäuseteils (11), der in den verbreiterten Bereich (6) der Nut (5) eingreift, bezüglich einer benachbarten Seitenwand (13) des zweiten Gehäuseteils (11) nach innen versetzt verläuft.

## Claims

1. Housing consisting of at least one first and one second housing part, which are connected together, and having at least one line or connection element introduced into the housing or guided out of the housing, wherein a peripheral slot (5) is provided in the first housing part (1), a peripheral edge (14, 15) provided on the second housing part (11) engaging in said slot (5) and simultaneously pressing the line or connection element (9) into the slot (5), wherein the slot (5) is at least partially filled with a cured sealant (19) that seals off the transition between the two housing parts (1, 11) and encloses the line or connection element (9), **characterized in that** the slot (5) is widened in the region (6) in which the line or connection element (9) is guided through the slot (5), wherein that portion (15) of the edge (14) of the second housing part (11) that engages in the widened region (6) of the slot (5) extends in a manner offset towards the inside with respect to an adjacent side wall (13) of the second housing part (11).

2. Housing according to Claim 1, **characterized in that** the edge (14) of the second housing part (11), apart from the edge portion (15) that acts on the line or connection element (9), rests on the bottom (2) of the slot (5) or is spaced apart therefrom.

3. Housing according to either of the preceding claims, **characterized in that** the portion (15) of the edge (14) has a substantially right-angled shape.

4. Housing according to one of the preceding claims, **characterized in that** a holding element (8), to which the line or connection element (9) is fixed, is provided on the wall side of the first housing part (1).

5. Housing according to Claim 4, **characterized in that** the holding element (8) is clamp- or clip-like and the line or connection element (9) is snap-fitted or pressfitted therein.

6. Housing according to Claim 4 or 5, **characterized in that** the holding element is fastened to a wall-side fastening portion (24), or **in that** it is formed integrally on the housing part (1).

7. Housing according to one of the preceding claims, **characterized in that** one or more holding-down means (17), under which the line or connection element (9) is clamped, are provided at the edge of the first housing part (1).

8. Housing according to one of the preceding claims, **characterized in that** a recess (16) is provided in one housing part (1, 11) or mutually corresponding recesses are provided in the outer walls of the two housing parts (1, 11), said recesses supplementing one another to form an opening through which the line or connection element (9) is guided.

9. Housing according to one of the preceding claims, **characterized in that** the sealant (19) is a sealing compound or a casting resin based on plastic.

10. Housing according to Claim 9, **characterized in that** the sealing compound is silicone-based or the casting resin is polyurethane-based or epoxy-based.

11. Housing according to one of the preceding claims, **characterized in that** the housing parts (1, 11) and optionally the holding element (8) are made of plastic.

12. Housing according to one of the preceding claims, **characterized in that** the two housing parts (1, 11) are connected together via latching connections or screw connections.

13. Housing according to one of the preceding claims, **characterized in that** the line or connection element (9, 10) is a cable, a metal wire, in particular in the form of a pin, or a transmitter or receiver element with an antenna.

14. Method for producing a housing that consists of at least one first and one second housing part, which are connected together and sealed off from one another, having at least one line or connection element that is guided into or out of the housing and is sealed off with respect to at least one housing part, in which
- either at least one cable (9) is introduced into the first housing part (1) and a fluid sealant (19) is introduced into a peripheral slot (5) formed in the first housing part (1), after which the second housing part (11) is inserted by way of a peripheral edge (14, 15) into the slot (5) such that the sealant (19) seals off the transition between the two housing parts (1, 11) in the slot (5) and the line or connection element (9, 10) is pushed by the edge (14, 15) under the level (20) of the sealant (19), after which the sealant cures,
- or at least one line or connection element (9) is introduced into the first housing part (1) and the second housing part (11) is inserted by way of a peripheral edge (14, 15) into a peripheral slot (5) formed in the first housing part (1) and the line or connection element (9) is pushed via the edge (14, 15) into the slot (5), after which a fluid sealant (19) that seals off the transition between the two housing parts (1, 11) in the slot (5) and encloses the line or connection element (9, 10) in the slot (5) is introduced into the slot (5) and subsequently cures,
wherein, in both cases, the slot (5) is widened in the region (6) in which the line or connection element (9) is guided through the slot (5), wherein that portion (15) of the edge (14) of the second housing part (11) that engages in the widened region (6) of the slot (5) extends in a manner offset towards the inside with respect to an adjacent side wall (13) of the second housing part (11).

## Revendications

1. Boîtier constitué d'au moins une première et une deuxième partie de boîtier qui sont reliées l'une à l'autre, et comportant au moins un élément de ligne ou de raccordement inséré dans le boîtier ou guidé hors du boîtier, une rainure périphérique (5) étant prévue sur la première partie de boîtier (1), rainure dans laquelle vient en prise un bord périphérique (14, 15) prévu sur la deuxième partie de boîtier (11), lequel bord presse simultanément l'élément de conduite ou de raccordement (9) dans la rainure (5), la rainure (5) étant remplie au moins partiellement d'un moyen d'étanchéité durci (19) qui réalise l'étanchéité de la transition entre les deux parties de boîtier (1, 11) et entoure l'élément de ligne ou de raccordement (9), **caractérisé en ce que** la rainure (5) est élargie dans la région (6) dans laquelle l'élément de ligne ou de raccordement (9) est guidé à travers la rainure (5), la partie (15) du bord (14) de la deuxième partie de boîtier (11) qui vient en prise dans la région élargie (6) de la rainure (5) s'étendant de manière décalée vers l'intérieur par rapport à une paroi latérale adjacente (13) de la deuxième partie de boîtier (11).

2. Boîtier selon la revendication 1, **caractérisé en ce que** le bord (14) de la deuxième partie de boîtier (11), hormis la partie de bord (15) qui s'applique sur l'élément de ligne ou de raccordement (9), repose sur le fond (2) de la rainure (5) ou est espacé de celui-ci.

3. Boîtier selon l'une des revendications précédentes, **caractérisé en ce que** la partie (15) du bord (14) présente une forme sensiblement rectangulaire.

4. Boîtier selon l'une des revendications précédentes, **caractérisé en ce qu'**un élément de retenue (8) auquel l'élément de ligne ou de raccordement (9) est fixé est prévu côté paroi sur la première partie de boîtier (1).

5. Boîtier selon la revendication 4, **caractérisé en ce que** l'élément de retenue (8) est de type pince ou clip et l'élément de ligne ou de raccordement (9) y est encliqueté ou enfoncé.

6. Boîtier selon la revendication 4 ou 5, **caractérisé en ce que** l'élément de retenue est fixé à une partie de fixation (24) côté paroi, ou **en ce qu'**il est formé d'une seule pièce sur la partie de boîtier (1).

7. Boîtier selon l'une des revendications précédentes, **caractérisé en ce qu'**un ou plusieurs éléments de maintien vers le bas (17) sont prévus sur le bord de la première partie de boîtier (1), éléments de maintien vers le bas sous lesquels l'élément de ligne ou de raccordement (9) est serré.

8. Boîtier selon l'une des revendications précédentes, **caractérisé en ce qu'**un évidement (16) est prévu sur une partie de boîtier (1, 11) ou des évidements correspondant les uns aux autres sont prévus sur les deux parties de boîtier (1, 11) sur les parois extérieures, lesquels évidements se complètent pour former une ouverture à travers laquelle l'élément de ligne ou de raccordement (9) est guidé.

9. Boîtier selon l'une des revendications précédentes, **caractérisé en ce que** le moyen d'étanchéité (19) est un matériau d'étanchéité ou une résine de coulée à base de matière synthétique.

10. Boîtier selon la revendication 9, **caractérisé en ce que** le matériau d'étanchéité est à base de silicone ou la résine de coulée est à base de polyuréthane ou à base d'époxy.

11. Boîtier selon l'une des revendications précédentes, **caractérisé en ce que** les parties de boîtier (1, 11) et éventuellement l'élément de retenue (8) sont constitués de matière synthétique.

12. Boîtier selon l'une des revendications précédentes, **caractérisé en ce que** les deux parties de boîtier (1, 11) sont reliées l'une à l'autre par le biais de liaisons par encliquetage ou de liaisons par vissage.

13. Boîtier selon l'une des revendications précédentes, **caractérisé en ce que** l'élément de ligne ou de raccordement (9, 10) est un câble, un fil métallique, en particulier sous la forme d'une broche, ou un élément d'émission ou de réception doté d'une antenne.

14. Procédé de fabrication d'un boîtier qui est constitué d'au moins une première et une deuxième partie de boîtier qui sont reliées l'une à l'autre et étanchéifiées l'une par rapport à l'autre, comportant au moins un élément de ligne ou de raccordement guidé dans le boîtier ou hors de celui-ci et étanchéifié par rapport à au moins une partie de boîtier, dans lequel
- soit au moins un câble (9) est inséré dans la première partie de boîtier (1) et un moyen d'étanchéité fluide (19) est introduit dans une rainure périphérique (5) formée sur la première partie de boîtier (1), après quoi la deuxième partie de boîtier (11) est insérée dans la rainure (5) par un bord périphérique (14, 15), de sorte que le moyen d'étanchéité (19) réalise l'étanchéité de la transition entre les deux parties de boîtier (1, 11) dans la rainure (5) et que l'élément de ligne ou de raccordement (9, 10) soit pressé par le biais du bord (14, 15) sous le niveau (20) du moyen d'étanchéité (19), après quoi le moyen d'étanchéité durcit,
- soit au moins un élément de ligne ou de raccordement (9) est inséré dans la première partie de boîtier (1) et la deuxième partie de boîtier (11) par un bord périphérique (14, 15) dans une rainure périphérique (5) formée sur la première partie de boîtier (1) et l'élément de ligne ou de raccordement (9) est pressé dans la rainure (5) par le biais du bord (14, 15), après quoi un moyen d'étanchéité fluide (19) réalisant l'étanchéité de la transition entre les deux parties de boîtier (1, 11) dans la rainure (5) et entourant l'élément de ligne ou de raccordement (9, 10) dans la rainure (5) est introduit dans la rainure (5), lequel moyen d'étanchéité durcit ensuite,
et, dans les deux cas, la rainure (5) étant élargie dans la région (6) dans laquelle l'élément de ligne ou de raccordement (9) est guidé à travers la rainure (5), la partie (15) du bord (14) de la deuxième partie de boîtier (11) qui vient en prise dans la région élargie (6) de la rainure (5) s'étendant de manière décalée vers l'intérieur par rapport à une paroi latérale adjacente (13) de la deuxième partie de boîtier (11).
